# EUROPÄISCHE PATENTSCHRIFT

(11) **EP 0 728 260 B1**
(45) Veröffentlichungstag und Bekanntmachung des Hinweises auf die Patenterteilung: **07.01.1999**
(21) Anmeldenummer: 94930935.5
(22) Anmeldetag: 28.10.1994
(51) Int. Cl.: F02D 41/34, G01R 23/10

(54) **ELEKTRONISCHE ZÄHLERSCHALTUNG**
ELECTRONIC METERING CIRCUIT
CIRCUIT DE COMPTAGE ELECTRONIQUE

(30) Priorität: 10.11.1993 DE 4338343
(43) Veröffentlichungstag der Anmeldung: 28.08.1996
(73) Patentinhaber: ROBERT BOSCH GMBH, 70442 Stuttgart (DE)
(72) Erfinder: EITRICH, Frank-Thomas, D-72760 Reutlingen (DE)
(86) Internationale Anmeldenummer: DE9401265
(87) Internationale Veröffentlichungsnummer: WO9513465

(56) Entgegenhaltungen:
- EP-A- 0 233 474
- DE-A- 2 640 791
- GB-A- 2 259 385

## Beschreibung

Die Erfindung betrifft eine elektronische Zählerschaltung zur zeitlichen Vergleichsmessung zwischen jeweils zwei aufeinanderfolgenden periodisch eintretenden Ereignissen.

### Stand der Technik

Bei der Messung der zeitlichen Länge eines Signals bzw. der Zeit zwischen dem Eintritt zweier Ereignisse ist es bekannt, an den Eingang einer zum Vergleicher gehörenden Zählerschaltung ein Taktsignal einer bestimmten Frequenz anzulegen. Durch eine Gatterlogik wird dieser Takt nur während der interessierenden Signalzeit zum Zähler durchgeschaltet und ansonsten ausgeblendet. Während der Ausblendung zählt der Zähler somit nicht weiter. Bei Rücksetzung des Zählerstandes während der nicht interessierenden Signalzeit, vorzugsweise auf den Wert Null, entspricht der Zählerstand näherungsweise der zeitlichen Länge des Signals. Ohne Rücksetzung des Zählerstandes entspricht die Zählerstanddifferenz dieser Signallänge. Zum Vergleich von Signalzeitverhältnissen zwischen jeweils zwei aufeinanderfolgenden periodisch eintretenden Ereignissen werden mindestens zwei dieser Zählerschaltungen benötigt bzw. ist eine Zwischenspeicherung von Zwischenergebnissen bei Verwendung nur einer Zählerschaltung in Registern notwendig. Hierbei ist neben dem zusätzlichen Bauelementeaufwand nachteilig, daß auf ein Signalzeitverhältnis nur durch Substraktion der von der Zählerschaltung gelieferten Zählerstände, wobei diese gegebenenfalls mit Konstanten zu bewerten sind, geschlossen werden kann.

Die GB 2 259 385 zeigt eine Zähleranordnung, die zur Zahnlückenerkennung bei einem Drehgeber für eine Kurbelwelle einer Brennkraftmaschine ausgelegt ist. Es sind zwei Zähler vorhanden, die um ein Winkelintervall versetzt arbeiten. Beide Zähler werden in einer ersten Phase aufwärts gezählt und in einer zweiten Phase abwärts gezählt. Die Zählfrequenzen sind für beide Phasen unterschiedlich. Eine Zahnlücke wird erkannt, wenn z.B. der erste Zähler ein negatives Vorzeichen aufweist. Die Zählfrequenzen für beide Phasen (Aufwärtszählvorgang und Abwärtszählvorgang) sind sehr genau aufeinander abgestimmt. Und zwar werden beide Zähler mit der Frequenz f heraufgezählt und mit der Frequenz f/K abwärtsgezählt. Der Teilerfaktor K ist dabei fest vorgegeben. Bei jeder zweiten ansteigenden Flanke eines Winkelimpulses werden die Zähler auf den Wert Null zurückgesetzt. Es können somit weder das Teilerverhältnis noch der Rückstellwert variiert werden.

### Vorteile der Erfindung

Die erfindungsgemäße elektronische Zählerschaltung gemäß den im Anspruch 1 genannten Merkmalen hat demgegenüber den Vorteil, daß mit einem einfachen Schaltungsaufbau die Zeitverhältnisse zwischen zweimal je zwei Ereignissen erkannt werden können. Dadurch, daß mit dem Eintritt eines ersten Ereignisses ein Vergleichszähler mit einem Rückstellwert geladen wird und der Vergleichszähler mit einer ersten Taktfrequenz zu zählen beginnt und beim Eintritt eines zweiten Ereignisses der Vergleichszähler mit einer zweiten Taktfrequenz bis zum Eintritt eines dritten Ereignisses in entgegengesetzter Richtung zu zählen beginnt und der Zählerstand zum Eintritt des dritten Ereignisses einen Vergleichswert für das Verhältnis der Signalzeiten zwischen dem Eintritt des ersten und zweiten Ereignisses und zwischen dem Eintritt des zweiten und dritten Ereignisses bildet, ist es in einfacher Weise sehr vorteilhaft möglich, die zeitliche Vergleichsmessung durch in verschiedene Richtungen ablaufende Zählvorgänge aufzulösen und anhand des Zählerstandes am Ende der Vergleichsmessung auf das Verhältnis der beiden Signalzeiten zu schließen.

Vorteilhaft ist dabei auch,
daß der Vergleichszähler von zwei getrennten Zählern gebildet wird, die eine verschiedene Zählrichtung besitzen. Hierdurch wird sehr vorteilhaft erreicht, daß der die erste Signalzeit bereitstellende Zähler bereits eine neue Messung durchführen kann, während der zweite Zähler die Vergleichsmessung durchführt.

Weitere vorteilhafte Ausgestaltungen der Erfindung ergeben sich aus den übrigen in den Unteransprüchen genannten Merkmalen.

### Zeichnung

Die Erfindung wird nachfolgend in Ausführungsbeispielen anhand der zugehörigen Zeichnungen näher erläutert. Es zeigen:
- Figur 1: ein Blockschaltbild einer elektronischen Zählerschaltung in einer ersten Ausführungsvariante und
- Figur 2: ein Blockschaltbild einer elektronischen Zählerschaltung in einer zweiten Ausführungsvariante.

### Beschreibung der Ausführungsbeispiele

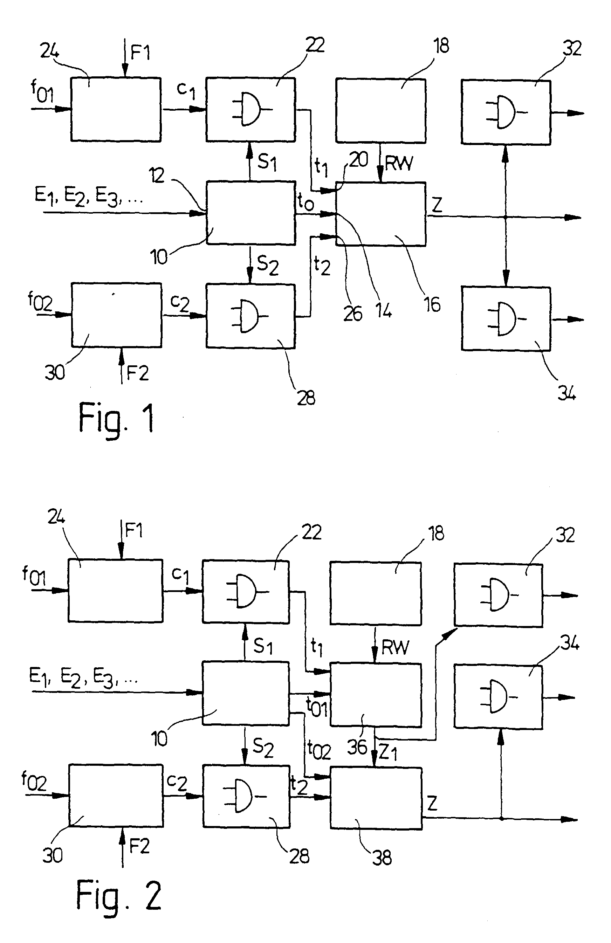

Das in Figur 1 dargestellte Blockschaltbild weist ein Steuerwerk 10 auf, das über einen Eingang 12 mit Ereignissignalen E1, E2 und E3 beaufschlagt wird. Die Ereignissignale E werden beispielsweise von einem auf einer Kurbelwelle einer Brennkraftmaschine angeordneten Geberrad erzeugt. Das Geberrad besitzt dabei über den Umfang verteilte Zähne, wobei jeder dieser Zähne ein Ereignissignal E bewirkt. Die Ereignissignale E können aber auch von einem beispielsweise auf einer Nockenwelle einer Brennkraftmaschine angeordneten Segmentgeber erzeugt werden, wobei beispielsweise eine positive Flanke ein erstes Ereignissignal E1 und eine negative Flanke ein zweites Ereignissignal E2 und die positive Flanke eines nächsten Segments ein drittes Ereignissignal E3 bewirkt.

Das Steuerwerk 10 ist mit einem ersten Eingang 14 eines Vergleichszählers 16 verbunden. Mit dem Eintritt eines Ereignissignals E1 gibt das Steuerwerk 10 an den Vergleichszähler 16 ein Signal t0, das bewirkt, daß der Vergleichszähler 16 mit einem Rückstellwert RW aus einem Register 18 geladen wird. Der Rückstellwert RW hat vorzugsweise einen Wert von Null. An einem zweiten Eingang 20 des Vergleichszählers 16 liegt eine Taktfrequenz t1 an, mit der der Vergleichszähler 16, beginnend mit dem Rückstellwert RW, aufwärts gezählt wird. Die Taktfrequenz t1 wird dabei von einer Gatterlogik 22 bereitgestellt, die einen Eingangstakt C1 durchstellt, wenn die Gatterlogik 22 mit einem von dem Steuerwerk 10 kommenden Steuersignal S1 beaufschlagt wird. Das Steuersignal S1 wird von dem Steuerwerk 10 dann ausgelöst, wenn das erste Ereignissignal E1 anliegt. Somit wird erreicht, daß der Vergleichszähler 16 zum Eintritt des ersten Ereignisses E1 auf den Rückstellwert RW geladen wird und gleichzeitig der Zähler mit der Taktfrequenz t1 gezählt wird. Die Taktfrequenz t1 löst dabei einen Zählvorgang um einen inkrementalen Wert, der vorzugsweise 1 beträgt, aus. Der Eingangstakt C1 wird von einer Frequenzteilerschaltung 24 bereitgestellt, wobei in an sich bekannter Weise eine von einer nicht dargestellten Steuerschaltung gelieferte Frequenz f01 mit einem vorgebbaren Frequenzteilungsfaktor F1 bewertet wird. Somit kann letztlich über den Frequenzteilungsfaktor F1 die Taktfrequenz t1 beeinflußt werden, mit der der Vergleichszähler 16 nach dem Eintritt des Ereignisses E1 zu zählen beginnt. Mit dem Eintritt eines zweiten Ereignisses E2 gibt das Steuerwerk 10 an den Vergleichszähler 16 ein neuerliches Signal t0, so daß der Vergleichszähler 16 den Zählvorgang mit der Taktfrequenz t1 stoppt. Gleichzeitig wird der Vergleichszähler 16 über einen dritten Eingang 26 mit einer Taktfrequenz t2 beaufschlagt. Die Taktfrequenz t2 bewirkt ein Abwärtszählen des Vergleichszählers 16, beginnend mit dem zu dem Eintritt des Ereignisses E2 erreichten Zählerstand. Hierbei wird ein Zählvorgang um einen inkrementalen Wert, vorzugsweise von -1, ausgelöst. Die Taktfrequenz t2 wird dabei von einer Gatterlogik 28 bereitgestellt, die einen Eingangstakt C2 in Abhängigkeit eines von dem Steuerwerk 10 bereitgestellten Steuersignals S2 durchstellt. Das Steuersignal S2 wird dabei mit dem Eintritt des zweiten Ereignisses E2 ausgelöst. Der Eingangstakt C2 wird von einer Frequenzteilerschaltung 30 geliefert, mit Hilfe derer eine von der nicht dargestellten Steuerschaltung gelieferten Frequenz f02 mit einem vorgebbaren Frequenzteilungsfaktor F2 bewertet wird. Somit wird die Taktfrequenz t2, mit der der Vergleichszähler 16 abwärts zählt, von dem Frequenzteilungsfaktor F2 bestimmt.

Mit dem Eintritt eines dritten Ereignisses E3 gibt das Steuerwerk 10 ein weiteres Signal t0 an den Vergleichszähler 16, so daß dieser seinen Zählvorgang stoppt. Mit dem Eintritt des Ereignisses E3 besitzt der Vergleichszähler 16 somit einen bestimmten Zählerstand Z. Da der mit dem Eintritt des ersten Ereignisses E1 geladene Rückstellwert RW bekannt ist, kann dieser mit dem nun zum Eintritt des Ereignisses E3 vorliegenden Zählerstand Z verglichen werden. Ist der Vergleichszähler 16 mit einer gleich großen Taktfrequenz t1 aufwärts und einer Taktfrequenz t2 abwärts gezählt worden, entspricht ein positiver Zählerstand Z der Aussage, daß die Signalzeit zwischen dem zweiten Ereignis E2 und dem dritten Ereignis E3 kleiner ist als die Signalzeit zwischen dem ersten Ereignis E1 und dem zweiten Ereignis E2.

Aus einem negativen Zählerstand Z kann geschlußfolgert werden, daß die Signalzeit zwischen den Ereignissen E2 und E3 größer ist als die Signalzeit zwischen den Ereignissen El und E2. Da die Taktfrequenzen t1 und t2 nicht notwendigerweise gleich groß sein müssen, sondern durch die Frequenzteilerfaktoren F1 und F2 vorgebbar sind, kann aus dem Verhältnis der Taktfrequenzen t2 zu t1 auf das Verhältnis der Signalzeiten zwischen den Ereignissen E1 und E2 bzw. den Ereignissen E2 und E3 geschlossen werden. Hierdurch wird erreicht, daß die Genauigkeit der zeitlichen Vergleichsmessung nur von den Taktfrequenzen t1 bzw. t2 und nicht von den von einem Geber bereitgestellten Ereignissignalen E abhängig ist. Das exakte Signalzeitverhältnis wird dabei durch den Rückstellwert RW charakterisiert. Der Zählerstand Z und gegebenenfalls der Zwischenzählerstand zum Eintritt des Ereignisses E2 kann, wie hier angedeutet, zur weiteren Auswertung beispielsweise den Gatterlogiken 32 und 34 zugeführt werden. Im Rahmen der vorliegenden Erfindung soll jedoch die Auswertung des Zählerstandes Z nicht weiter berücksichtigt werden.

Das beschriebene Beispiel geht davon aus, daß der Rückstellwert RW einen Wert von Null besitzt und der Vergleichszähler 16 mit jedem inkrementalen Wert von dem Rückstellwert RW weg- bzw. auf diesen zu gezählt wird. Indem man die unteren Bits des Vergleichszählers 16 nicht berücksichtigt, kann bei einem Rückstellwert RW gleich Null, eine "etwas größeres Verhältnis" Funktion realisiert werden, so daß die Aussage, die Signalzeit zwischen den Ereignissen E2 und E3 ist etwas größer als die Signalzeit zwischen den Ereignissen E1 und E2, möglich ist, ohne diese genau zu bewerten.

Wird der Vergleichszähler 16 mit einem Rückstellwert ungleich Null gestartet, können auch Funktionen wie "etwas kleineres Verhältnis" und "etwa gleiches Verhältnis" erreicht werden. Der Genauigkeitsbereich dieser Funktionen hängt dabei von der Zahl der nicht verwendeten Bits des Vergleichszählers 16 und den vorgebbaren, gegebenenfalls programmierbaren Frequenzteilerfaktoren F1 und F2 ab. Die Breite der "etwa Bereiche" ist dabei lediglich von der Taktfrequenz t2 und die Genauigkeit von den Taktfrequenzen t1 und t2 abhängig. Weiterhin können durch die Vergabe eines Rückstellwertes RW von ungleich Null oder den teilweisen Verzicht auf das Rückstellen des Vergleichszählers 16 während der Signalzeit zwischen den Ereignissen E2 und E3 weitere von der Taktfrequenz t1 abhängige Funktionen realisiert werden.

In der Figur 2 ist ein Blockschaltbild dargestellt, das eine bevorzugte Ausführung der in Figur 1 gezeigten Ausführung darstellt. Gleiche Teile wie in Figur 1 sind mit gleichen Bezugszeichen versehen und hier nicht nochmals erläutert. Anstelle des Vergleichszähler 16 ist hier ein erster Zähler 36 angeordnet, der mit einem von dem Steuerwerk 10 ausgehenden Signal t01 bei Eintritt des Ereignisses E1 mit dem Rückstellwert RW geladen wird. Der Zähler 36 beginnt nunmehr mit der Taktfrequenz t1 aufwärts zu zählen. Mit dem Eintritt des zweiten Ereignisses E2 wird der momentane Zählerstand Z1 des Zählers 36 in einen zweiten Zähler 38 übernommen. Der zweite Zähler 38 wird über ein von dem Steuerwerk 10 abgegebenes Signal t02 gestartet, das den Eintritt des zweiten Ereignisses E2 repräsentiert und mit der Taktfrequenz t2 abwärts gezählt. Der zweite Zähler 38 stellt dann mit dem Eintritt des Ereignisses E3, wie bereits zu Figur 1 beschrieben, den Zählerstand Z zur Verfügung. Hiermit wird erreicht, daß durch die Verlagerung der Vergleichsmessung in den zweiten Zähler 38 der erste Zähler 36 sofort mit einer neuen Signalzeitmessung beginnen kann. Dies ist jedoch erst dann möglich, wenn der Zählerstand des ersten Zählers 36 mit dem Eintritt des Ereignisses E2 in den zweiten Zähler 38 übergeben wurde. Der Zählerstand Z1 und der Zählerstand Z können auch hier einer weiteren Verarbeitung durch die Gatterlogiken 32 und 34 zugeführt werden.

Die in den Figuren 1 und 2 dargestellten Zählerschaltungen sind lediglich beispielhaft, so können selbstverständlich die Zählrichtungen auch vertauscht sein. Dies bedeutet, daß mit der Taktfrequenz t1 der Vergleichszähler 16 bzw. der erste Zähler 36 abwärts und mit der Taktfrequenz t2 der Vergleichszähler 16 bzw. der zweite Zähler 38 aufwärts gezählt werden. Darüber hinaus ist es möglich, den Vergleichszähler 16 als einen gemischt zählenden Zähler auszubilden, so daß dieser über die anliegenden Taktfrequenzen t1 und t2 gleichzeitig hoch- bzw. runtergezählt werden kann.

## Patentansprüche

1. Elektronische Zählerschaltung zur zeitlichen Vergleichsmessung zwischen jeweils durch Flankenwechsel eines bestimmten Eingangssignals charakterisierten Ereignissen, wobei mit dem Eintritt eines ersten Ereignisses (E1) ein Vergleichszähler (16) mit einer ersten Taktfrequenz (t1) zu zählen beginnt und mit dem Eintritt eines zweiten Ereignisses (E2) der Vergleichszähler (16) mit einer zweiten Taktfrequenz (t2) bis zum Eintritt eines dritten Ereignisses (E3) in entgegengesetzter Richtung zu zählen beginnt, wobei der Zählerstand des Vergleichszählers (16) ein Vergleichswert für das Verhältnis der Signalzeiten zwischen dem Eintritt des ersten und zweiten Ereignisses und zwischen dem zweiten und dritten Ereignis bildet,wobei dem Vergleichszähler (16) ein Register (18) zugeordnet ist, in das ein Rückstellwert für den Vergleichszähler ladbar ist, wobei beim Eintritt des ersten Ereignisses (E1) der Vergleichszähler mit dem Rückstellwert aus dem Register (18) geladen wird, wobei dem Vergleichszähler (16) weiterhin eine erste Frequenzteilerschaltung (24) zugeordnet ist, die die erste Taktfrequenz (t1) liefert, und deren Frequenzteilungsfaktor (F1) vorgebbar ist und wobei dem Vergleichszähler (16) weiterhin eine zweite Frequenzteilerschaltung (30) zugeordnet ist, die die zweite Taktfrequenz (t2) liefert, und deren Frequenzteilungsfaktor (F2) vorgebbar ist, die die zweite Taktfrequenz (t2) liefert.

2. Elektronische Zählerschaltung nach Anspruch 1 dadurch gekennzeichnet, daß der Rückstellwert (RW) vorzugsweise 0 beträgt.

3. Elektronische Zählerschaltung nach einem der vorhergehenden Ansprüche, dadurch gekennzeichnet, daß die erste Taktfrequenz (t1) aus einem Eingangstakt (C1) gebildet wird, der in Abhängigkeit des ersten Ereignisses (E1) durch eine Gatterlogik bereitgestellt wird.

4. Elektronische Zählerschaltung nach einem der vorhergehenden Ansprüche, dadurch gekennzeichnet, daß die zweite Taktfrequenz (t2) aus einem Eingangstakt (C2) gebildet wird, der in Abhängigkeit des Eintritts des zweiten Ereignisses (E2) durch eine Gatterlogik (28) bereitgestellt wird.

5. Elektronische Zählerschaltung nach einem der vorhergehenden Ansprüche, dadurch gekennzeichnet, daß der Vergleichszähler von zwei getrennten Zählern (36; 38) gebildet wird, die eine verschiedene Zählrichtung besitzen.

6. Elektronische Zählerschaltung nach Anspruch 5, dadurch gekennzeichnet, daß der erste Zähler (36) vorzugsweise aufwärts zählt.

7. Elektronische Zählerschaltung nach Anspruch 5, dadurch gekennzeichnet, daß der zweite Zähler (38) vorzugsweise abwärts zählt.

8. Elektronische Zählerschaltung nach einem der Ansprüche 5 bis 7, dadurch gekennzeichnet, daß mit dem Eintritt des zweiten Ereignisses (E2) der Zählerstand (Z1) des ersten Zählers (36) in den zweiten Zähler (38) übertragen wird.

9. Elektronische Zählerschaltung nach einem der Ansprüche 5 bis 8, dadurch gekennzeichnet, daß mit dem Eintritt des zweiten Ereignisses (E2) der erste Zähler (36) gleichzeitig mit dem Rückstellwert (RW) geladen wird.

10. Elektronische Zählerschaltung nach einem der vorhergehenden Ansprüche, dadurch gekennzeichnet, daß der Vergleichszähler (16) gemischt zählt, wobei die erste Taktfrequenz (t1) einen Zählvorgang um einen inkrementalen Wert, vorzugsweise 1 auslöst und die zweite Taktfrequenz
(t2) einen Zählvorgang um einen inkrementalen Wert, vorzugsweise -1, auslöst.

11. Elektronische Zählerschaltung nach einem der vorhergehenden Ansprüche, dadurch gekennzeichnet, daß die Ereignisse (E) durch einen Drehwinkelgeber erzeugt werden und zyklischen Winkel informationen eines Aggregates entsprechen.

12. Elektronische Zählerschaltung nach Anspruch 11, dadurch gekennzeichnet, daß das Aggregat die Kurbelwelle einer Brennkraftmaschine ist.

13. Elektronische Zählerschaltung nach Anspruch 11, dadurch gekennzeichnet, daß das Aggregat die Nockenwelle einer Brennkraftmaschine ist.

14. Elektronische Zählerschaltung nach einem der vorhergehenden Ansprüche, dadurch gekennzeichnet, daß die elektronische Zählerschaltung in einem Steuergerät einer Brennkraftmaschine zur Zahnlückenerkennung eines Inkrementgebersignals der Kurbelwelle eingesetzt wird.

15. Elektronische Zählerschaltung nach einem der vorhergehenden Ansprüche, dadurch gekennzeichnet, daß die elektronische Zählerschaltung in einem Steuergerät einer Brennkraftmaschine zur Zahnlückenerkennung eines Inkrementgebersignals der Nockenwellen eingesetzt wird.

16. Elektronische Zählerschaltung nach einem der vorhergehenden Ansprüche, dadurch gekennzeichnet, daß die elektronische Zählerschaltung in einem Steuergerät einer Brennkraftmaschine zur Synchronisationssignalerkennung eines Segmentgebersignals der Kurbelwelle eingesetzt wird.

17. Elektronische Zählerschaltung nach einem der vorhergehenden Ansprüche, dadurch gekennzeichnet, daß die elektronische Zählerschaltung in einem Steuergerät einer Brennkraftmaschine zur Synchronisationssignalerkennung eines Segmentgebersignals der Nockenwelle eingesetzt wird.

18. Elektronische Zählerschaltung nach einem der vorhergehenden Ansprüche, dadurch gekennzeichnet, daß die elektronische Zählerschaltung in einem Steuergerät einer Brennkraftmaschine zur Nachbildung der Kurbelwelle eingesetzt wird.

19. Elektronische Zählerschaltung nach einem der vorhergehenden Ansprüche, dadurch gekennzeichnet, daß die elektronische Zählerschaltung in einem Steuergerät einer Brennkraftmaschine zur Nachbildung der Nockenwelle eingesetzt wird.

## Claims

1. Electronic counter circuit for time comparison measurement between events which are in each case characterized by a flank change of a specific input signal, a comparison counter (16) starting to count at a first clock frequency (t1) when a first event (E1) occurs, and the comparison counter (16) starting to count at a second clock frequency (t2) when a second event (E2) occurs and until a third event (E3) in the opposite direction occurs, the count of the comparison counter (16) forming a comparison value for the ratio of the signal times between the occurrence of the first and the second event and between the second and the third event, the comparison counter (16) being allocated a register (18) into which a reset value for the comparison counter can be loaded, the comparison counter being loaded with the reset value from the register (18) when the first event (E1) occurs, the comparison counter (16) furthermore being allocated a first frequency divider circuit (24) which supplies the first clock frequency (t1) and whose frequency division factor (F1) can be predetermined, and the comparison counter (16) furthermore being allocated a second frequency divider circuit (30) which supplies the second clock frequency (t2) and whose frequency division factor (F2) can be predetermined, which supplies the second clock frequency (t2).

2. Electronic counter circuit according to Claim 1, characterized in that the reset value (RW) is preferably 0.

3. Electronic counter circuit according to one of the preceding claims, characterized in that the first clock frequency (t1) is formed from an input clock (C1) which is provided by a gauge logic device as a function of the first event (E1).

4. Electronic counter circuit according to one of the preceding claims, characterized in that the second clock frequency (t2) is formed from an input clock (C2) which is provided by a gauge logic device (28) as a function of the occurrence of the second event (E2).

5. Electronic counter circuit according to one of the preceding claims, characterized in that the comparison counter is formed by two separate counters (36; 38) which have a different counting direction.

6. Electronic counter circuit according to Claim 5, characterized in that the first counter (36) preferably counts upwards.

7. Electronic counter circuit according to Claim 5, characterized in that the second counter (38) preferably counts downwards.

8. Electronic counter circuit according to one of Claims 5 to 7, characterized in that, when the second event (E2) occurs, the count (Z1) of the first counter (36) is transferred to the second counter (38).

9. Electronic counter circuit according to one of Claims 5 to 8, characterized in that, when the second event (E2) occurs, the first counter (36) is at the same time loaded with the reset value (RW).

10. Electronic counter circuit according to one of the preceding claims, characterized in that the comparison counter (16) counts in a mixed manner, the first clock frequency (t1) initiating a counting process by an incremental value, preferably 1, and the second clock frequency (t2) initiating a counting process by an incremental value, preferably -1.

11. Electronic counter circuit according to one of the preceding claims, characterized in that the events (E) are produced by a rotation angle sensor and correspond to cyclic angular information items about an assembly.

12. Electronic counter circuit according to Claim 11, characterized in that the assembly is the crankshaft of an internal combustion engine.

13. Electronic counter circuit according to Claim 11, characterized in that the assembly is the camshaft of an internal combustion engine.

14. Electronic counter circuit according to one of the preceding claims, characterized in that the electronic counter circuit is used in a controller of an internal combustion engine in order to identify tooth gaps in an incremental sensor signal from the crankshaft.

15. Electronic counter circuit according to one of the preceding claims, characterized in that the electronic counter circuit is used in a controller of an internal combustion engine in order to identify tooth gaps in an incremental sensor signal from the camshafts.

16. Electronic counter circuit according to one of the preceding claims, characterized in that the electronic counter circuit is used in a controller of an internal combustion engine for synchronization signal identification of a segment sensor signal from the crankshaft.

17. Electronic counter circuit according to one of the preceding claims, characterized in that the electronic counter circuit is used in a controller of an internal combustion engine for synchronization signal identification of a segment sensor signal from the camshaft.

18. Electronic counter circuit according to one of the preceding claims, characterized in that the electronic counter circuit is used in a controller of an internal combustion engine to model the crankshaft.

19. Electronic counter circuit according to one of the preceding claims, characterized in that the electronic counter circuit is used in a controller of an internal combustion engine to model the camshaft.

## Revendications

1. Circuit de comptage électronique servant à effectuer une mesure de comparaison dans le temps entre respectivement des événements respectivement caractérisés par un changement de flanc d'un signal d'entrée déterminé,
caractérisé par
un compteur de comparaison (16) commençant à compter avec une première fréquence de synchronisation (t1) à l'entrée d'un premier événement (E1) et le compteur de comparaison (16) commençant à compter en sens opposé avec l'entrée d'un deuxième événement (E2) avec une deuxième fréquence de synchronisation (t2) jusqu'à l'entrée d'un troisième événement (E3), l'état du compteur de comparaison (16) formant une valeur de comparaison pour le rapport des durées des signaux entre l'entrée du premier événement et celle du deuxième événement et entre le deuxième et le troisième événement, un registre (18) étant associé au compteur de comparaison (16), registre dans lequel on peut charger une valeur de remise à l'état initial pour le compteur de comparaison, le compteur de comparaison étant chargé avec la valeur de remise à l'état initial à partir du registre (18) lors de l'entrée du premier événement (E1), un premier circuit diviseur de tension (24) étant en outre associé au compteur de comparaison (16), circuit diviseur de tension (24) qui délivre la première fréquence de synchronisation (t1), et dont on peut prédéfinir le facteur (F1) de division de la tension, et un second circuit diviseur de tension (30) étant en outre associé au compteur de comparaison (16), second circuit diviseur de tension (30) qui délivre la seconde fréquence de synchronisation (t2), et dont on peut définir au préalable le facteur (F2) de division de la tension qui délivre la seconde fréquence de synchronisation (t2).

2. Circuit électronique de comptage selon la revendication 1,
caractérisé en ce que
la valeur de remise à l'état initial (RW) est de préférence égale à zéro.

3. Circuit électronique de comptage selon l'une des revendications précédentes,
caractérisé en ce que
la première fréquence de synchronisation (t1) est formée à partir d'un signal de synchronisation d'entrée (C1) qui est fourni en fonction du premier événement (E1) par un circuit logique à intersecteur.

4. Circuit électronique de comptage selon l'une des revendications précédentes,
caractérisé en ce que
la deuxième fréquence de synchronisation (t2) est formée à partir d'un signal de synchronisation d'entrée (C2) qui est fourni en fonction de l'entrée du deuxième événement (E2) par un circuit logique à intersecteur (28).

5. Circuit électronique de comptage selon l'une des revendications précédentes,
caractérisé en ce que
le compteur de comparaison est formé par deux compteurs séparés (36; 38) qui possèdent un sens de comptage différent.

6. Circuit électronique de comptage selon la revendication 5,
caractérisé en ce que
le premier compteur (36) compte de préférence en montant.

7. Circuit électronique de comptage selon la revendication 5,
caractérisé en ce que
le deuxième compteur (38) compte de préférence en descendant.

8. Circuit électronique de comptage selon l'une des revendications 5 à 7,
caractérisé en ce que
l'état (Z1) du premier compteur (36) est transféré dans le deuxième compteur (38) avec l'entrée du deuxième événement (E2).

9. Circuit électronique de comptage selon l'une des revendications 5 à 8,
caractérisé en ce que
le premier compteur (36) avec l'entrée du deuxième événement (E2) est chargé en même temps avec la valeur de remise à l'état initial (RW).

10. Circuit électronique de comptage selon l'une des revendications précédentes,
caractérisé en ce que
me compteur de comparaison (16) compte de façon mixte, la première fréquence de synchronisation (t1) déclenchant un processus de comptage d'une valeur incrémentielle, de préférence la valeur 1, et la deuxième fréquence de synchronisation (t2) déclenchant un processus de comptage d'une valeur incrémentielle, de préférence la valeur -1.

11. Circuit électronique de comptage selon l'une des revendications précédentes,
caractérisé en ce que
les événements (E) sont produits par un capteur d'angle de rotation et correspondent à des informations cycliques sur les angles d'un sous-ensemble.

12. Circuit électronique de comptage selon l'une des revendications précédentes,
caractérisé en ce que
le sous-ensemble est l'arbre de vilebrequin d'un moteur à combustion interne.

13. Circuit électronique de comptage selon la revendication 11,
caractérisé en ce que
le sous-ensemble est l'arbre à cames d'un moteur à combustion interne.

14. Circuit électronique de comptage selon l'une des revendications précédentes,
caractérisé en ce que
le circuit électronique de comptage est utilisé dans un appareil de commande d'un moteur à combustion interne pour identifier les intervalles de dents d'un signal de capteur incrémentiel de l'arbre de vilebrequin.

15. Circuit électronique de comptage selon l'une des revendications précédentes,
caractérisé en ce que
le circuit électronique de comptage est utilisé dans un appareil de commande d'un moteur à combustion interne pour identifier les intervalles de dents d'un signal de capteur incrémentiel des arbres à cames.

16. Circuit électronique de comptage selon l'une des revendications précédentes,
caractérisé en ce que
le circuit électronique de comptage est utilisé dans un appareil de commande d'un moteur à combustion interne pour identifier les signaux de synchronisation d'un capteur de segments de l'arbre de vilebrequin.

17. Circuit électronique de comptage selon l'une des revendications précédentes,
caractérisé en ce que
le circuit électronique de comptage est utilisé dans un appareil de commande d'un moteur à combustion interne pour identifier les signaux de synchronisation d'un capteur de segments de l'arbre à cames.

18. Circuit électronique de comptage selon l'une des revendications précédentes,
caractérisé en ce que
le circuit électronique de comptage est utilisé dans un appareil de commande d'un moteur à combustion interne pour reproduire l'arbre de vilebrequin.

19. Circuit électronique de comptage selon l'une des revendications précédentes
caractérisé en ce que
le circuit électronique de comptage est utilisé dans un appareil de commande d'un moteur à combustion interne pour reproduire l'arbre à cames.
